Europäisches Patentamt

European Patent Office

Office européen des brevets

(19)

(11)     EP 0 662 721 B1

(12)     FASCICULE DE BREVET EUROPEEN

(45) Date de publication et mention
de la délivrance du brevet:
07.04.2004   Bulletin 2004/15

(51) Int Cl.⁷: **H01L 31/0203**, H01L 27/146,
H01L 25/16, H01L 21/60

(21) Numéro de dépôt: 95400024.6

(22) Date de dépôt: 05.01.1995

(54) **Détecteur de rayonnement électromagnétique et procédé de fabrication**

Elektromagnetischer Strahlungsdetektor und Herstellungsverfahren

Electromagnetic radiation detector and method of fabrication

(84) Etats contractants désignés:
**DE GB IT**

(30) Priorité: **07.01.1994  FR 9400115**

(43) Date de publication de la demande:
**12.07.1995   Bulletin 1995/28**

(73) Titulaire: **COMMISSARIAT A L'ENERGIE
ATOMIQUE
75015 Paris Cédex 15 (FR)**

(72) Inventeurs:
 • **Marion, François
   F-38120 Saint Egreve (FR)**
 • **Guiga, Angelo
   F-38220 Tullins (FR)**
 • **Boitel, Michelle
   F-38600 Fontaine (FR)**
 • **Gaude, Gilbert
   F-38360 Noyarey (FR)**

(74) Mandataire: **Poulin, Gérard et al
BREVALEX
3, rue du docteur Lancereaux
75008 Paris (FR)**

(56) Documents cités:
**US-A- 4 783 594         US-A- 4 871 921
US-A- 5 264 699**

• **ELECTRONICS & COMMUNICATIONS IN JAPAN,
  PART II - ELECTRONICS, vol.71, no.11, 1988,
  NEW YORK US pages 19 - 27 T. SOGA ET AL.
  'Development of a high-reliability Flip-Chip
  packaging reinforced by resin'**
• **43RD ELECTRONIC COMPONENTS &
  TECHNOLOGY CONFERENCE, 1 Juin 1993,
  ORLANDO, FLORIDA pages 175 - 181 J.
  CLEMENTI ET AL. 'Flip-Chip encapsulation on
  ceramic substrates'**
• **IBM TECHNICAL DISCLOSURE BULLETIN.,
  vol.32, no.10B, Mars 1990, NEW YORK US pages
  476 - 477 'Direct chip bonding with bump on
  substrate'**
• **43RD ELECTRONIC COMPONENTS &
  TECHNOLOGY CONFERENCE, 1 Juin 1993,
  ORLANDO, FLORIDA pages 780 - 784 D.W.
  WANG ET AL. 'Encapsulant for fatigue life
  enhancement of controlled collapse chip
  connection (C4)'**

EP 0 662 721 B1

**Description**

DOMAINE TECHNIQUE

L'invention a pour objet un détecteur de rayonnement électromagnétique ainsi qu'un procédé de fabrication d'un tel capteur.

Un domaine spectral particulièrement concerné par l'invention est le domaine de l'infrarouge, le détecteur étant alors un capteur infrarouge.

L'invention trouve donc des applications dans le domaine de l'optoélectronique, en particulier dans le domaine de l'optoélectronique infrarouge.

ETAT DE LA TECHNIQUE

Les circuits et composants pour la détection de rayonnements électromagnétiques, notamment dans l'infrarouge, doivent souvent être utilisés à des températures basses, entre 4 K et 200 K et plus particulièrement vers 77 K, afin de minimiser le bruit de fond qui se superpose au signal, lorsque ce dernier est de niveau relativement faible (régime de comptage de photons, par exemple). C'est le cas, notamment, pour les détecteurs dans le domaine de l'infrarouge.

Mais, les matériaux dont sont composés ces détecteur, ainsi que leur structure, ne sont pas toujours compatibles avec des excursions à basse température. En particulier, différents matériaux peuvent être employés pour les différentes parties du détecteur, et ces matériaux n'ont pas tous des coefficients de dilatation thermique identiques ou voisins. Il en résulte parfois des déformations pouvant être importantes et pouvant même aboutir à des ruptures mécaniques au bout de quelques descentes à basse température.

C'est notamment le cas pour les détecteurs de rayonnement infrarouge (I.R.) obtenus par hybridation d'une couche de matériau détecteur I.R. sur un circuit de silicium. La technique d'hybridation utilisée peut être, par exemple, la technique d'hybridation par billes dite aussi "flip Chip".

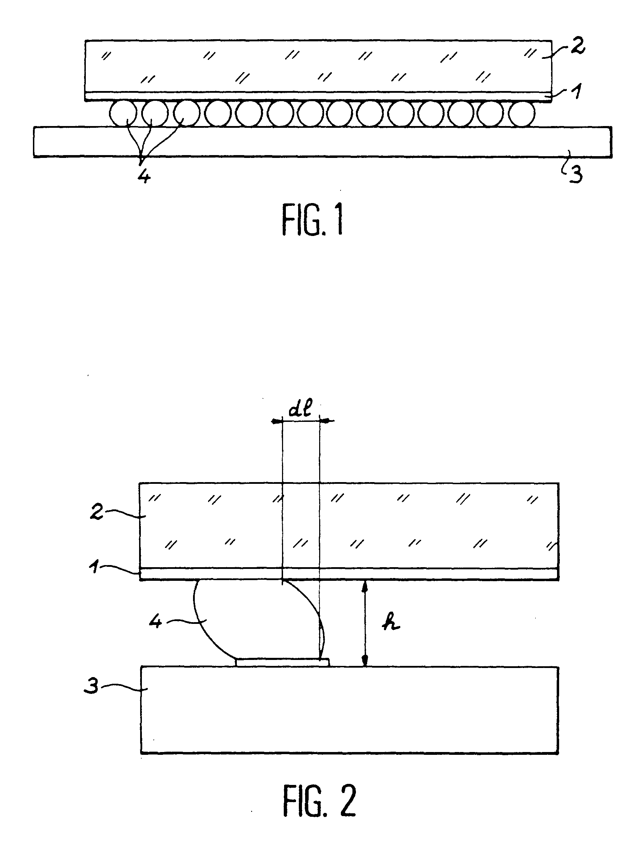

Un détecteur obtenu par une telle technique présente la structure illustrée sur la figure 1.

Sur cette figure, la référence 1 désigne une couche d'un matériau sensible au rayonnement électromagnétique à détecter, par exemple CdHgTe pour l'infrarouge. Cette couche est déposée sur un substrat 2 transparent au rayonnement à mesurer. Dans le cas de la couche en CdHgTe, le substrat peut être en CdTe. Des éléments de photodétection qui peuvent être du type photovoltaïque ou photoconducteur (diodes P/N par exemple) sont réalisés sur cette couche de CdHgTe. La référence 3 désigne un circuit de silicium, destiné à la lecture du signal électrique obtenu. L'ensemble couche de matériau détecteur + substrat est hybridé sur le silicium de lecture à l'aide de billes 4. La taille de ces billes est de l'ordre de quelques dizaines de micromètres et le procédé d'hybridation est décrit dans l'art antérieur, par exemple dans la demande de brevet FR-A-2646558 du 26 AVRIL 1989.

La figure 2 illustre le phénomène physique qui se produit lors d'excursions à basses température. Sur cette figure, les références 1 à 4 ont la même signification que sur la figure 1. Si h représente la hauteur d'une bille (égale à la distance entre la face de la couche de matériau détecteur tourné vers le silicium et la surface de ce dernier), l la distance de la bille considérée au barycentre de l'ensemble des billes, $\Delta\alpha$ la différence entre le coefficient de dilatation du silicium et celui du matériau de détection, $\Delta T$ l'amplitude de l'excursion en température, alors, les billes subissent un cisaillement dl tel que $\frac{dl}{h} = l\Delta\alpha\Delta T$.

A titre d'exemple, pour un matériau détecteur à base de tellure de cadmium, on observe une dilatation différentielle de 6 µm/cm entre le silicium et ce matériau lorsque la température varie de 373 K à 77 K. Une bille située à 1 cm du centre géométrique d'un composant subira donc une déformation latérale de 6 µm ; soit, pour une bille de hauteur h=20 µm, une déformation relative $\frac{dl}{h} = \frac{6}{20}$ = 30%, ce qui est considérable.

Ce type de problème s'est déjà posé dans un autre domaine technique. Il s'agit de celui des composants électroniques, où on rencontre également de telles structures hybridées par billes.

Un premier type de solution, dans ce domaine, consiste à accroître la hauteur h entre deux surfaces hybridées afin de limiter la déformation relative $\frac{dl}{h}$. On obtient ce résultant en empilant des couches de billes. Ce procédé est décrit dans un article de N. Matsui et al. intitulé "VLSI chip interconnection technology using stacked solder bumps", publié dans IEEE Transactions on Components, Hybrids and Manufacturing Technology, vol. 12, N°4, Décembre 1987. Mais cette technique est de mise en oeuvre délicate et les tests réalisés sur ces structures n'ont pas mis en jeu de températures inférieure à -70°C. (Rappelons que le problème posé ci-dessus concerne des excursions aussi basses que 4 K, soit environ -269°C).

De plus, elle ne permet pas de supprimer définitivement les problèmes de défaillance des billes, mais ne fait que retarder l'échéance de cette défaillance.

Un autre procédé pour améliorer la résistance mécanique de circuits électroniques hybridés est connu et expliqué dans l'article intitulé : "Development of a high reliability flip chip packaging reinforced by resin" publié dans "Electronics and communications in Japan", part 2, vol. 71, n°11, 1988, p.19, et dans le document "Flip Chip solder bump fatigue life enhanced by polymer encapsulation", publié dans "Proceeding of the 40th Electronic Components and Technology Conference", 1990, p. 338.

Le procédé décrit dans ces documents est un procédé d'enrobage des composants électroniques. Ce procédé consiste à déposer une goutte calibrée d'une substance d'enrobage telle qu'une résine d'enrobage (appelée plus simplement, par la suite, résine). Cette goutte calibrée de résine est déposée près du composant électronique hybridé par billes, ce composant électronique étant, dans la plupart des cas, une puce électronique. La goutte de résine déposée près du composant électronique migre par capillarité sous le composant électronique, c'est-à-dire que cette goutte de résine migre vers les billes du composant hybridé situées entre le composant et le substrat. La goutte de résine doit être correctement calibrée de façon à ce que la quantité de résine qu'elle contient soit suffisamment importante pour combler entièrement l'espace contenu entre le composant hybridé et le substrat, mais elle ne doit pas être trop importante dé façon à ce que la résine ne s'étale pas trop autour dudit composant hybridé. En outre, afin de limiter cet "étalement" non désirable de la résine autour du composant hybridé, la goutte de résine doit être déposée très précisément au bord du composant hybridé. En effet, si la goutte de résine a un volume trop important, la résine risque de s'étendre largement autour du composant recouvrant, de ce fait, des zones qui sont proches dudit composant et qui ne doivent pas être recouvertes. Par conséquent, cette technique est assez délicate de mise en oeuvre. De plus, les composants obtenus sont conçus pour descendre à des températures de l'ordre de -55°C, mais pas en-dessous. Or, le problème au départ de la présente invention concerne des températures aussi basses que 4 K (c'est-à-dire environ -269°C) pour lesquelles les solutions de l'art antérieur ne peuvent être transposées.

Un document de l'art antérieur, le brevet US-A-5 264 699, traite des détecteurs infrarouges hybridés, et en particulier de leur résistance à la déformation lors d'excursions à basse température. Un tel détecteur comporte un substrat transparent dans le domaine de longueurs d'ondes à détecter, une couche de matériau de détection et un substrat de lecture sur lequel l'ensemble substrat-couche de matériau de détection est hybridé à l'aide de billes en indium. Un matériau époxy peut être utilisé pour combler les espaces entre les billes et améliorer la liaison entre l'ensemble de détection et le substrat de lecture. La solution que propose ce brevet au problème des excursions aux basses températures est de limiter l'épaisseur de l'ensemble constitué par le substrat transparent et la couche de matériau détecteur.

EXPOSE DE L'INVENTION

La présente invention a pour but de remédier aux inconvénients donnés ci-dessus, en améliorant la structure du détecteur de rayonnement électromagnétique.

De façon plus précise, la présente invention a pour objet un détecteur de rayonnement électromagnétique comportant :

- une couche mince de matériau semi-conducteur de détection, sensible au rayonnement à détecter, et présentant une première et une deuxième faces, la première face étant exposée directement au rayonnement à détecter, cette couche mince de matériau semi-conducteur étant hybridée par des microbilles sur un circuit de lecture,
- un enrobage en résine entourant la couche mince de matériau semi-conducteur et présentant une lèvre qui déborde en avant de la première face de la couche mince.

De façon préférée, la lèvre de l'enrobage de résine présente une surface plane.

Le rayonnement à détecter peut être un rayonnement infrarouge, le matériau constitutif de la couche mince étant alors à base de CdHgTe.

Enfin, selon un autre mode particulier de réalisation de l'invention, le détecteur défini ci-dessus est de plus caractérisé en ce que la résine possède un coefficient de dilatation thermique proche de celui du matériau constitutif du circuit de lecture.

L'invention a aussi pour objet un procédé de fabrication d'un détecteur de rayonnement électromagnétique comportant les étapes suivantes :

- une étape de dépôt d'une couche de matériau semi-conducteur de détection, sensible au rayonnement à détecter, sur un substrat,
- une étape d'hybridation de la couche mince de matériau semi-conducteur, à l'aide de microbilles, sur un circuit de lecture,
- une étape d'enrobage, par une résine, de l'ensemble constitué du substrat, de la couche mince de matériau sensible au rayonnement à détecter et des microbilles, de façon à ce que la couche mince soit comprise entre la résine et le substrat, la résine étant retenue entre les microbilles sauf pour une partie qui forme une lèvre sur les bords du substrat et de la couche mince,
- une étape d'amincissement mécanique de l'ensemble constitué par la résine et le substrat,
- une étape d'amincissement chimique du substrat consistant à tremper l'ensemble couche mince-substrat dans un bain chimique épargnant tous les constituants du circuit sauf le matériau constitutif du substrat et enlevant tout résidu dudit substrat.

Le circuit de lecture peut être réalisé sur une tranche de silicium.

Le procédé peut comporter, entre l'étape de dépôt de la couche de matériau sensible au rayonnement à détecter sur le substrat et l'étape d'enrobage par une résine, une étape de découpe de l'ensemble substrat-couche mince, de façon à former des circuits individuels de photodétection, l'étape d'hybridation, l'étape d'enrobage et les deux étapes d'amincissement étant réalisées de façon collective.

De toute façon, les caractéristiques et avantages de l'invention apparaîtront mieux à la lumière de la description qui va suivre. Cette description porte sur les exemples de réalisations, donnés à titre explicatif et non limitatif. Elle se réfère par ailleurs à des dessins annexés sur lesquels :

- la figure 1, déjà décrite, représente un détecteur de rayonnement selon l'art antérieur,
- la figure 2, déjà décrite, représente le phénomène de cisaillement se produisant dans un détecteur selon l'art antérieur,
- la figure 3 représente un détecteur selon l'invention,
- la figure 4 représente une étape de réalisation d'un procédé de fabrication d'un détecteur selon l'invention,
- la figure 5 représente une autre étape de réalisation d'un procédé de fabrication d'un détecteur selon l'invention,
- la figure 6 représente le composant obtenu après l'étape d'hybridation par microbilles,
- les figures 7a et 7b représentent l'étape d'enrobage par résine à l'aide d'un tapis de microbilles contigu au composant à enrober,
- la figure 8 représente le composant obtenu après l'étape d'amincissement mécanique,
- la figure 9 représente l'étape de découpage finale du procédé.

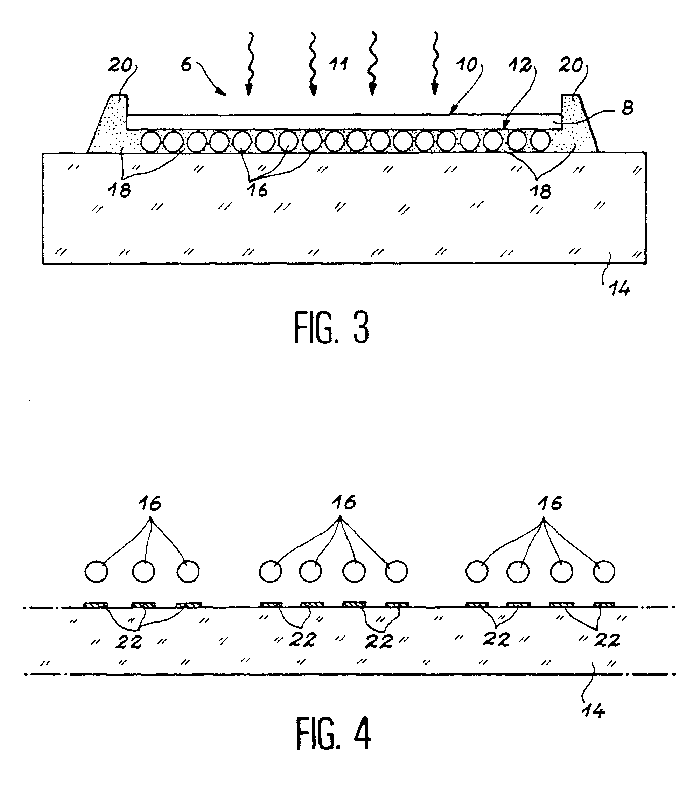

La figure 3 représente un détecteur 6 comportant une couche 8 de matériau sensible à un rayonnement électromagnétique ayant des caractéristiques données. Cette couche présente une première face 10 (dirigée vers le haut sur la figure 3) et une deuxième face 12 (dirigée vers le bas sur la figure 3). Le rayonnement 11 à mesurer arrive directement sur la première face 10.

Cette couche de matériau détecteur est hybridée sur un circuit de lecture 14, par exemple en silicium, l'hybridation est réalisée avec des microbilles 16, du type de celles utilisées dans les composés hybridés, en microélectronique.

Ces billes peuvent, par exemple, être réalisées par croissance électrolytique d'une couche d'un matériau à bas point de fusion (par exemple Sn-Pb ou indium) au-dessus d'une surface mouillable (par exemple une surface d'or) de surface plus faible. Ces billes peuvent ensuite être mises en forme par fusion du matériau, les forces de tension superficielles formant les billes soudées sur la surface mouillable. Des modes de réalisation de ces billes utilisées pour l'hybridation de composants électroniques sont décrits dans les documents cités précédemment. On peut également citer, à ce sujet, l'ouvrage intitulé "Microelectronic Packaging Handbook" Edited by R.R. Tummala et al., p. 361-391.

Le détecteur est enrobé par une résine 18 qui couvre la deuxième face 12 de la couche 8 de matériau détecteur et qui entoure cette couche 8 en présentant une lèvre 20 qui déborde en avant de la première face 10 de la couche. De préférence, cette lèvre a une partie horizontale par rapport aux faces de la couche de matériau détecteur, et forme une sorte de table comme indiqué sur la figure 3.

Le détecteur ainsi décrit présente une très grande stabilité lors d'excursions à très basses températures, car toutes les billes subissent une dilatation différentielle réduite et les problèmes de billes extérieures sont éliminés.

La lèvre 20 permet de stabiliser la structure et de renforcer la résistance mécanique de l'ensemble lors de ces excursions basses températures.

Pour détecter un rayonnement situé dans l'infrarouge, on pourra choisir, par exemple, un matériau détecteur à base de CdHgTe. CdHgTe représente un composé ternaire pour lequel l'homme du métier saura définir, suivant les applications envisagées plus spécifiquement, les rapports stoechiométriques.

Un procédé de réalisation d'un tel détecteur sera maintenant décrit.

1. Une première étape concerne la réalisation collective des circuits de lecture 14 sur une tranche de silicium ainsi que des plots 22 sur lesquels s'appuieront les billes 16 nécessaires à l'étape d'hybridation (voir figure 4). On utilisera pour cela les méthodes traditionnelles de réalisation collective de circuits intégrés en silicium. Ces circuits seront ensuite munis de billes pour l'hybridation. On peut trouver une description d'un procédé de réalisation de ces microbilles dans le livre intitulé "Microelectronic Pakaging Handbook, édité par R.R. Tummala et al., p. 361-391.

Un test électrique des circuits de lecture silicium peut être prévue, suivie d'une étape de repérage des circuits électroniques à hybrider.

2. Une deuxième étape, qui peut être mise en oeuvre parallèlement à la première, est consacrée à la réalisation de la couche mince 8 de matériau pour la détection du rayonnement. Cette couche mince est déposée sur un substrat 26, par un procédé classique de dépôt des couches minces, tel que l'épitaxie. Dans le cas de l'exemple déjà cité (matériau de détection = CdHgTe), on choisira par exemple un substrat CdTe, mais d'autres matériaux peuvent être utilisés. On obtient donc une couche mince 8 de matériau détecteur pouvant avoir une épaisseur de l'ordre de quelques micromètres.

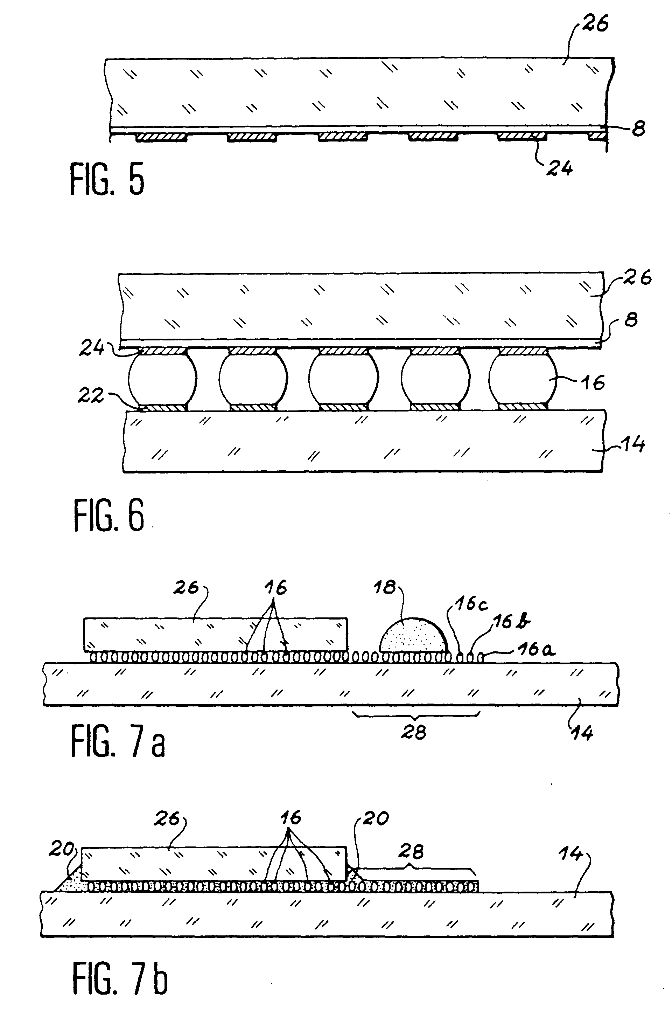

Les plots de contact 24 qui viendront s'appuyer sur les billes 16 lors de l'étape suivante d'hybridation sont alors réalisés (figure 5). Puis le substrat 26, porteur de la couche 8 et des plots 24, est découpé pour former des circuits de photodétection.

3. On peut alors réaliser, dans une troisième étape, l'hybridation collective des circuits de photodétection sur la tranche comportant les circuits de lecture 14, à l'aide des microbilles 16 et des plots 24 et 22.

Le procédé d'hybridation décrit dans la demande de brevet FR-A-2646558 peut être utilisé ; ce procédé peut aisément être mis en oeuvre de façon collective.

Le matériau des billes 16 sera choisi tel, qu'à l'état liquide, il mouille bien les métaux dont sont constitués les plots 22 et 24, comme l'or, mais ne mouille pas ou mouille très mal les matériaux constitutifs de l'environnement de ces plots (c'est-à-dire la couche 8 de détection elle-même et les circuits de lecture). D'autre part, ce procédé nécessitant d'élever la température jusqu'au point de fusion des billes, celles-ci devront être constituées d'un matériau dont la température de fusion est suffisamment faible pour ne pas détériorer les composants lors de l'interconnexion de ceux-ci.

Compte tenu de ces deux conditions, un matériau tel que l'indium, l'étain ou le plomb ou un alliage métallique à bas point de fusion contenant l'un de ces matériaux conviennent bien pour les billes 16.

Lorsqu'on a mis en contact les billes 16 d'une part avec les plots 22 des circuits de lecture 14 et d'autre part avec les plots 24 de la face 12 de la couche 8 de chacun des circuits de photodétection, on procède à une montée en température de l'ensemble obtenu, jusqu'à la température de fusion du matériau constitutif des billes.

L'assemblage est ensuite refroidi naturellement.

Pendant le chauffage de l'ensemble et jusqu'au refroidissement de celui-ci, l'un des composants, par exemple le circuit de lecture 14, est maintenu (il est par exemple posé sur un support horizontal non représenté) tandis que les circuits de photodétection sont libres, par exemple au-dessus du circuit 14.

L'ensemble obtenu par ce procédé est illustré sur la figure 6, où les références ont la même signification que sur les figures 4 et 5. Un seul circuit de photodétection est représenté sur cette figure 6.

Ce procédé présente les avantages suivants :

- l'interconnexion réalisée est très résistante puisqu'une véritable soudure des billes sur les plots est réalisée ; l'arrachement de deux composants permet d'ailleurs de voir que la cassure se produit non pas aux interfaces billes/plots mais après étirement et rupture des billes.
- l'assemblage obtenu résiste très bien au vieillissement, aux cycles thermiques à très basse température et aux vibrations.
- le rendement d'hybridation est excellent, le nombre de rejets étant voisin de 0. Les plots ne peuvent être court-circuités puisque chaque bille ne peut être soudée à aucun autre élément que les plots, du fait du choix des matériaux.
- la mise en oeuvre de ce procédé provoque un phénomène d'autoalignement des composants et nécessite de ce fait une précision d'alignement plus faible que celle qui est nécessaire avec les procédés de l'art antérieur.

4. Chacun des ensembles ainsi préparé (c'est-à-dire chaque couche de détection sur substrat, hybridée par bille sur les circuits de lecture de la tranche de silicium) est ensuite enrobé dans une résine.

L'homme du métier pourra choisir une résine ayant une viscosité adaptée et un coefficient de dilatation proche du silicium.

La méthode d'enrobage est une méthode dans laquelle la localisation de la résine peut être contrôlée pendant et après l'opération d'enrobage dudit composant hybridé.

Elle peut être aisément mise en oeuvre de façon collective, c'est-à-dire pour l'enrobage d'un certain nombre de circuits de photodétection hybridés.

Cette méthode consiste :

- à disposer des billes sur les circuits de la tranche de silicium, afin de former un tapis de billes à proximité de la couche de détection hybridée que l'on veut enrober,
- à déposer au moins une goutte d'une substance d'enrobage (ou résine) sur le tapis de billes, les billes du tapis imprégnées de la substance étant aptes à faire migrer cette substance par capillarité vers les autres billes du tapis.

Il est préférable de disposer le tapis de billes contigument au circuit de détection hybridé à enrober. De cette façon, les billes du tapis assurent la migration de la substance d'enrobage vers les billes situées entre ledit détecteur et le circuit de lecture en silicium.

Sur les figures 7a et 7b, on a représenté le circuit de détection hybridé sur les circuits de lecture de la tranche de silicium 14. Un tapis de billes 28 est réalisé au moyen d'une multitude de billes (16a, 16b, 16c, ...) identiques aux billes 16. Ce tapis 28 de billes est disposé de façon contiguë aux billes 16 du circuit de détection hybridé. Une goutte de résine 18 est ensuite déposée sur le tapis 28 (figure 7a). Les forces de capillarité vont avoir deux effets :

- la résine 18 s'étend à toutes les billes du tapis 28 de billes ainsi qu'à toutes les billes 16 de la surface sous le circuit de photodétection (figure 7b).
- la résine 18 est retenue dans la limite du tapis de billes, sauf pour une petite partie qui forme, également sous l'effet des forces de capillarité, une lèvre 20 sur les bords du circuit de photodétection (figure 7b).

Quel que soit l'emplacement du tapis de billes auquel on dépose la goutte de résine, cette dernière est aspirée par le tapis et dirigée vers le circuit de photodétection hybridé contigu sous lequel elle est également aspirée. L'excédent de résine dispensé reste confiné dans le tapis 28 de billes, outre la poutre qui forme la lèvre 20 sur les bords.

Un cycle de réticulation de la résine est alors effectué selon les spécifications propres à la résine utilisée.

5. L'étape ultérieure est une étape d'amincissement, par des moyens mécaniques communément employés dans l'industrie des composants électroniques (par exemple par rodage mécanique).

Cette étape est destinée à :

- supprimer les excès de résine d'enrobage 18 pouvant se fissurer à basse température (77 K),
- réaliser une première attaque du substrat 26 (par exemple CdTe) sur lequel est déposé la couche mince 8 de matériau détecteur,
- aplanir les lèvres 20 de résine d'enrobage créées le long du circuit de détection lors de l'étape n°4.

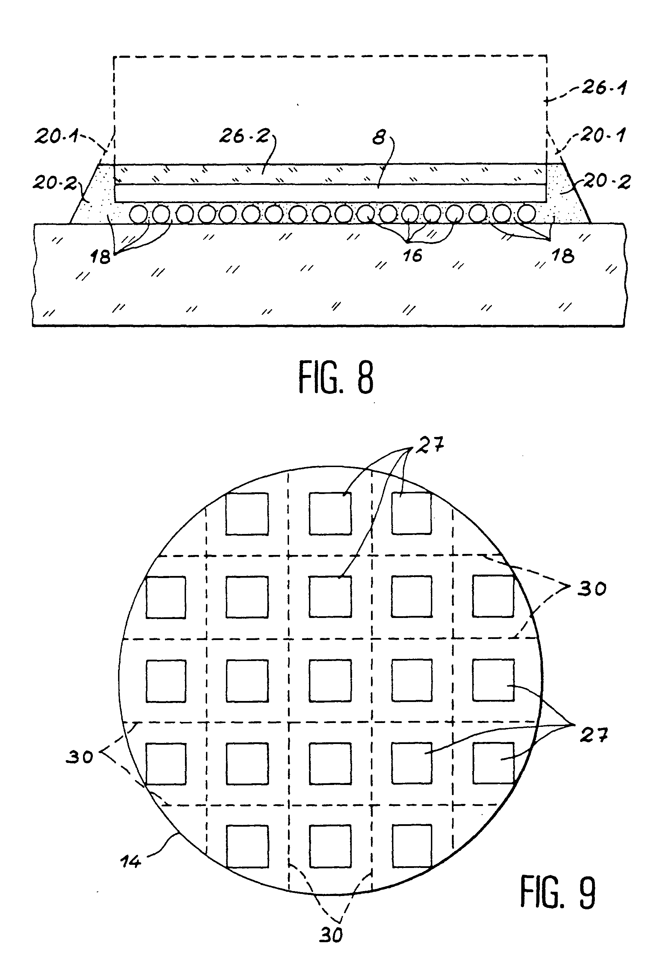

On a représenté, sur la figure 8, cette étape d'amincissement mécanique.

Sur cette figure, les références 8, 14, 16, 18 ont la même signification que sur la figure 3. On a représenté, en pointillés, les parties 26-1 du substrat 26 et 20-1 de la lèvre 20 qui sont supprimées à l'issue de l'étape d'amincissement mécanique. Les références 26-2 et 20-2 représentent la partie du substrat et de la lèvre qui reste intacte après cette étape.

Il n'est pas nécessaire d'atteindre, par l'amincissement mécanique, une grande précision. Par exemple, on tolérera une hauteur entre le haut du circuit de détection et la surface de silicium de 50 $\mu$m ±20 $\mu$m pour des hauteurs de billes par exemple de 10 à 30 $\mu$m.

6. Une deuxième étape d'amincissement est ensuite réalisée, mais par des moyens chimiques. Elle est destinée à enlever tout résidu 26-2 de substrat non enlevé par l'amincissement mécanique au cours de l'étape 5 (voir figure 5).

Si par exemple les billes ont une hauteur de 20 $\mu$m, la couche de matériau de détection une épaisseur de 5 $\mu$m et que l'amincissement mécanique a laissé une épaisseur résiduelle de 50 $\mu$m, il s'agit de retirer 50 - (20+5)=25 $\mu$m de substrat.

Ce résidu de substrat sera supprimé par immersion de la tranche entière de silicium porteuse des circuits de photodétection hybridés dans un bain chimique épargnant tous les constituants des circuits, sauf le matériau constitutif du substrat 26.

Ce bain sera également très sélectif sur le matériau constitutif des couches de détection 8. Un tel bain peut être par exemple constitué d'un mélange d'acide fluorhydrique, d'acide nitrique et d'acide acétique.

Ce deuxième amincissement laisse une "marche" entre la partie aplanie de la lèvre 20 de résine située sur le pourtour du détecteur et le matériau 8 de la couche de détection.

C'est cette lèvre 20 qui contribue à la stabilité mécanique de l'ensemble, lors d'excursions à très basses températures.

Après aplanissement mécanique, la résine et le substrat sont au même niveau de hauteur (voir figure 8). Mais, après aplanissement chimique le substrat 26 est éliminé alors que la résine n'est pas ou moins affectée par l'attaque chimique. Chacune de ces étapes d'amincissement (mécanique et chimique) sera mise en oeuvre, de façon avantageuse, de façon collective.

Chacun des circuits muni d'un détecteur peut ensuite être testé fonctionnellement.

7. Chacun des composants "circuit de lecture + circuit de détection", testé bon fonctionnellement, peut alors être traité suivant les procédés classiques de fin de procédé des technologies silicium, à savoir :

- découpe des circuits à la scie rotative : on obtient ainsi un détecteur tel que représenté sur la figure 3. Cette étape de découpe est illustrée sur la figure 9 sur laquelle la référence 27 désigne plusieurs circuits de photodétection, chacun étant hybridé sur un circuit de lecture et enrobé de résine, la référence 30 désigne les lignes de découpe entre les différents composants et la référence 14 le substrat en silicium,
- montage par fil (ball bonding/wedge bonding) dans un boîtier et/ou une céramique.

L'ensemble des étapes décrites permet de traiter des plaques de silicium entières et d'utiliser des machines développées pour les industries microélectroniques (manipulation, hybridation, enrobage, amincissement mécanique et chimique, découpe, etc...). De plus, chacune des étapes décrites ci-dessus peut aisément être mise en oeuvre de façon collective et on peut ainsi fabriquer des détecteurs selon l'invention en grande série et à moindre coût.

## Revendications

1. Détecteur de rayonnement électromagnétique comportant :

- une couche mince de matériau semi-conducteur de détection (8), sensible au rayonnement à détecter, et présentant une première et une deuxième faces (10, 12), la première face étant exposée directement au rayonnement à détecter, cette couche mince (8) de matériau semi-conducteur (8) étant hybridée par des microbilles (16) sur un circuit de lecture (14),

- un enrobage en résine (18) entourant la couche mince de matériau semi-conducteur (8) et présentant une lèvre (20) qui déborde en avant de la première face (10) de la couche mince (8).

2. Détecteur selon la revendication 1, **caractérisé en ce que** la lèvre (20) de l'enrobage de résine présente une surface plane.

3. Détecteur selon l'une des revendications précédentes, **caractérisé en ce que** le rayonnement à détecter est un rayonnement infrarouge et **en ce que** le matériau de détection est à base de CdHgTe.

4. Détecteur selon l'une des revendications 1 à 3, **caractérisé en ce que** la résine (18) possède un coefficient de dilatation thermique proche de celui du matériau constitutif du circuit de lecture (14).

5. Procédé de fabrication d'un détecteur de rayonnement électromagnétique comportant les étapes suivantes :

- une étape de dépôt d'une couche de matériau semi-conducteur de détection (8), sensible au rayonnement à détecter, sur un substrat (26),
- une étape d'hybridation de la couche mince (8) de matériau semi-conducteur, à l'aide de microbilles (16), sur un circuit de lecture,
- une étape d'enrobage, par une résine, de l'ensemble constitué du substrat (26), de la couche mince (8) de matériau sensible au rayonnement à détecter et des microbilles, de façon à ce que la couche mince (8) soit comprise entre la résine (18) et le substrat (26), la résine étant retenue entre les microbilles sauf pour une partie qui forme une lèvre (20) sur les bords du substrat et de la couche mince,
- une étape d'amincissement mécanique de l'ensemble constitué par la résine (18) et le substrat (26),
- une étape d'amincissement chimique du substrat (26) consistant à tremper l'ensemble couche mince-substrat-circuit de lecture dans un bain chimique épargnant tous les constituants du circuit de photodétection hybridé sauf le matériau constitutif du substrat (26) et enlevant tout résidu dudit substrat (26).

6. Procédé selon la revendication 5, **caractérisé en ce que** le circuit de lecture est réalisé sur une tranche de silicium (14).

7. Procédé selon la revendication 6, **caractérisé en**

ce qu'il comporte, entre l'étape de dépôt de la couche (8) de matériau sensible au rayonnement à détecter sur le substrat et l'étape d'enrobage par une résine, une étape de découpe de l'ensemble substrat (26)-couche mince (8), de façon à former des circuits individuels de photodétection, et **en ce que** l'étape d'hybridation, l'étape d'enrobage et les deux étapes d'amincissement sont réalisées de façon collective.

8. Procédé selon la revendication 7, **caractérisé en ce qu'**il comporte une étape de découpage de la tranche de silicium (14), de façon à former des composants individuels, composés chacun d'un circuit de photodétection sur un circuit de lecture.


**Patentansprüche**

1. Elektromagnetischer Strahlungsdetektor, umfassend:

- eine dünne Schicht aus einem für die zu detektierende Strahlung empfindlichen Detektions-Halbleitermaterial (8) mit einer ersten und einer zweiten Fläche (10, 12), wobei die erste Fläche der zu detektierenden Strahlung direkt ausgesetzt ist und diese dünne Schicht (8) aus Halbleitermaterial (8) durch Mikrokugeln (16) in hybrider Bauweise auf eine Leseschaltung (14) montiert ist,
- eine Umhüllung (18) aus Harz, welche die dünne Schicht aus Halbleitermaterial (8) umgibt und eine Lippe (20) aufweist, die über die erste Fläche (10) der dünnen Schicht (8) hinausragt.

2. Detektor nach Anspruch 1, **dadurch gekennzeichnet, dass** die Lippe (20) der Harzumhüllung eine ebene Oberfläche aufweist.

3. Detektor nach einem der vorangehenden Ansprüche, **dadurch gekennzeichnet, dass** die zu detektierende Strahlung eine Infrarot-Strahlung ist, und dass das Detektionsmaterial auf CdHgTe basiert.

4. Detektor nach einem der Ansprüche 1 bis 3, **dadurch gekennzeichnet, dass** das Harz (18) einen Wärmedehnungskoeffizienten nahe demjenigen des die Leseschaltung (14) bildenden Materials hat.

5. Verfahren zur Herstellung eines elektromagnetischen Strahlungsdetektors, das die folgenden Schritte umfasst:

- einen Abscheidungsschritt einer Schicht aus einem für die zu detektierende Strahlung empfindlichen Detektions-Halbleitermaterial (8) auf einem Substrat (26),

- einen Schritt zur Hybridisierung der dünnen Schicht (8) aus Halbleitermaterial mit Hilfe von Mikrokugeln (16) auf einer Leseschaltung,

- einen Schritt zur Umhüllung der aus dem Substrat (26), der dünnen Schicht (8) aus einem für die zu detektierende Strahlung empfindlichen Material und der Mikrokugeln (16) bestehenden Einheit mit einem Harz, so dass die dünne Schicht (8) zwischen dem Harz (18) und dem Substrat (26) enthalten ist, wobei das Harz zwischen den Mikrokugeln zurückgehalten wird, außer in dem Teil, der eine Lippe (20) bildet, welche die Ränder des Substrats und der dünnen Schicht umgibt,

- ein Schritt des mechanischen Dünnermachens des durch das Harz (18) und das Substrat (26) gebildeten Teils,

- ein Schritt des chemischen Dünnermachens des Substrats (26), darin bestehend, die Einheit aus dünner Schicht, Substrat und Leseschaltung in ein chemisches Bad zu tauchen, das die Bauteile der hybridisierten Fotodetektionsschaltung nicht angreift, aber das Substrat (26) angreift und den gesamten Rest dieses Substrats (26) beseitigt.

6. Verfahren nach Anspruch 5, **dadurch gekennzeichnet, dass** die Leseschaltung auf einer Siliciumscheibe (14) realisiert wird.

7. Verfahren nach Anspruch 6, **dadurch gekennzeichnet, dass** es zwischen dem Abscheidungsschritt der Schicht (8) aus dem für die zu detektierende Strahlung empfindlichen Material auf dem Substrat und dem Schritt zur Umhüllung mit einem Harz einen Schritt des Zuschneidens der Einheit aus Substrat (26) und dünner Schicht (8) umfasst, um einzelne Fotodetektionsschaltungen zu bilden, und dadurch, dass die Hybridisierungsschritt, der Umhüllungsschritt und die beiden Dünnermachungsschritte kollektiv realisiert werden.

8. Verfahren nach Anspruch 7, **dadurch gekennzeichnet; dass** es einen Schritt des Zuschneidens der Siliciumscheibe (14) umfasst, um einzelne Bauteile zu bilden, jedes bestehend aus einer Fotodetektionsschaltung auf einer Leseschaltung.

## Claims

1. Electromagnetic radiation detector comprising:

- a thin detection semiconductor material film (8), which is sensitive to the radiation to be detected, and which has a first face (10) and a second face (12), the first face being directly exposed to the radiation to be detected, said thin semiconductor material film (8) being hybridized by microbumps (16) on a reading circuit (14),

- a resin coating (18) surrounding the thin semiconductor material film (8) and having a lip (20) projecting beyond the first face (10) of the thin film (8).

2. Detector according to claim 1, **characterized in that** the resin coating lip (20) has a planar surface.

3. Detector according to one of the preceding claims, **characterized in that** the radiation to be detected is an infrared radiation and **in that** the detection material is based on CdHgTe.

4. Detector according to one of the claims 1 to 3, **characterized in that** the resin (18) has a thermal expansion coefficient close to that of the constituent material of the reading circuit (14).

5. Process for the production of an electromagnetic radiation detector having the following stages:

- a stage of depositing a thin detection semiconductor material film (8), which is sensitive to the radiation to be detected, on a substrate (26),

- a stage of hybridizing the thin semiconductor material film (8) on a reading circuit with the aid of microbumps (16),

- a stage of coating by a resin the assembly constituted by the substrate (26), the thin material film (8) sensitive to the radiation to be detected and the microbumps, so that the thin film (8) is located between the resin (18) and the substrate (26), the resin being retained between the microbumps, except for one part which forms a lip (20) on the edges of the substrate and the thin film,

- a stage of mechanically reducing the thickness of the assembly constituted by the resin (18) and the substrate (26),

- a stage of chemically reducing the thickness of the substrate (26) consisting of immersing the thin film-substrate-reading circuit assembly in a chemical bath, whilst retaining all the constituents of the hybridized photodetection circuit except for the constituent material of the substrate (26) and removing all residues from said substrate (26).

6. Process according to claim 5, **characterized in that** the reading circuit is produced on a silicon wafer (14).

7. Process according to claim 6, **characterized in that**, between the stage of depositing the film (8) of material sensitive to the radiation to be detected on the substrate and the resin coating stage, it involves a stage of cutting the substrate (26)-thin film (8) assembly, so as to form individual photodetection circuits and **in that** the hybridization stage, the coating stage and the two thickness reducing stages are performed collectively.

8. Process according to claim 7, **characterized in that** it involves a stage of cutting the silicon wafer (14) so as to form individual components, each being constituted by a photodetection circuit on a reading circuit.

FIG. 1

FIG. 2

FIG. 3

FIG. 4

FIG. 5

FIG. 6

FIG. 7 a

FIG. 7 b

FIG. 8

FIG. 9